# EUROPEAN PATENT APPLICATION

(11) **EP 4 156 275 A1**
(43) Date of publication of application: **29.03.2023**
(21) Application number: 21198313.5
(22) Date of filing: 22.09.2021
(51) Int. Cl.: H01L 27/22, G11C 11/16, H01L 43/02

(54) **1-BIT 3-TERMINAL RACETRACK ARRAY WITH INTEGRATED MAGNETIC TUNNEL JUNCTION (MTJ)**

(71) Applicant: Max-Planck-Gesellschaft zur Förderung der Wissenschaften e.V., 80539 München (DE)
(72) Inventor: PARKIN, Stuart S.P., Dr., Prof., 06118 Halle (DE); YANG, See-Hun, Dr., 06114 Halle (DE); PI, Unghwan, Dr., Hwasung-City, Gyeonggi-do 445-701 (KR); JEONG, Jaewoo, Dr., Milpitas, CA 95035 (US)
(74) Representative: Schweitzer, Klaus

(57) **Abstract**

The present invention relates to racetrack memory array devices, and more specifically, to a manufacturing method of racetrack memory arrays with integrated magnetic tunnel junction for read/write.

## Description

The present invention relates to racetrack memory array devices, and more specifically, to a manufacturing method of racetrack memory arrays with integrated magnetic tunnel junction for read/write.

### BACKGROUND

Racetrack memory (RTM) is a type of non-volatile magnetic memory that utilizes the current-controlled motion of magnetic domain walls (DW) in a thin strip or pillar of magnetic material, e.g., ferromagnetic material that forms the racetrack (e.g. US2011051490A1, US2014204647A1, US2014141530A1). Multiple magnetic domain walls are shifted through and along the racetrack driven by current pulses which are passed along the racetrack. In typical configurations, a magnetic tunnel junction (MTJ) is located at a distinct location along the racetrack; the MTJ is used to read out the device by sensing the magnetization of the strip as domain walls are shifted along the racetrack. The most advantageous racetracks are formed from thin magnetic layers that exhibit a significant perpendicular magnetic anisotropy (PMA) which means that the magnetization either points out of or into the substrate-plane. As domain walls are moved through and along such a PMA racetrack-substrate the magnetization changes its orientation from out-of-plane to in-plane or vice-versa. The MTJ can detect this change in orientation.

Especially, the so-called 1-bit 3-terminal racetrack memory is an emerging and promising device that has the potential to replace SRAM since it allows for similar performance, but has a much smaller footprint and, moreover, is non-volatile (e.g. USA 2013/0175645). The 1-bit 3-terminal racetrack memory can be extended to a manybits many-terminal racetrack memory. Recent developments, especially spin-orbit torques (SOTs) and exchange coupling torques (ECTs) (e.g. US-B 10,839,930) yield an highly efficient current-induced DW motion, that give a clear path to the development of a high-speed commercial racetrack memory.

Typically, RTM manufacturing concepts involve its fabrication in the back-end-of-line (BEOL). This conventional manufacturing technique comprises the layer having the magnetic domains - the RT layer - which is typically followed by a layer for read and write units - the MTJ layer. For interconnection, the read and write units are connected to metallic electrodes which are arranged as an outermost layer.

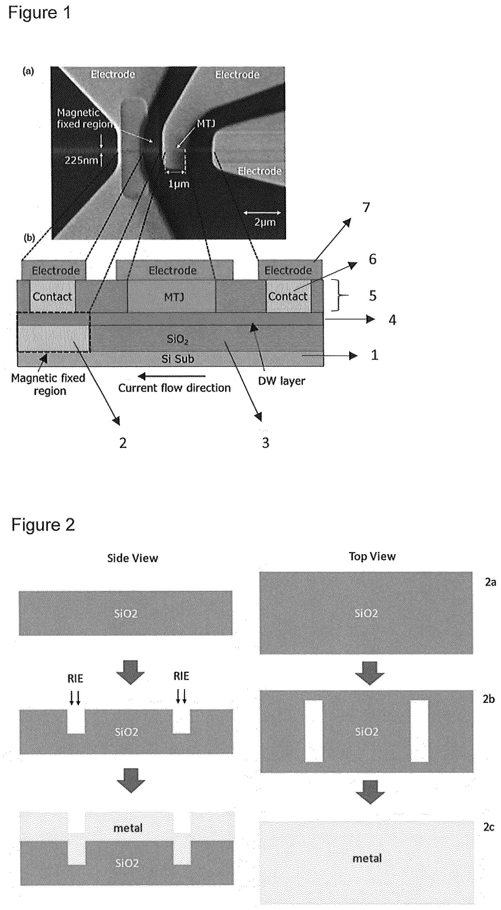

Figure 1 a and b shows such a typical conventional RT chip design. Figure 1a is an electron micrograph and figure 1b is a graphical representation showing the layered design of the chip with the silicon substrate (1) being the bottom layer and subsequent embedded magnetic fixed region (2) - typically a hard magnetic material - within the SiO₂ layer (3) followed by the RT layer (4) and the MTJ layer (5) and electrical contacts (6) and the top metallic layer forming the electrodes (7).

Such conventional RTM concepts using the above-described manufacturing sequence still suffer from problems:
1. In an RTM using SOT and ECT driven DW motion the RT layer typically is arranged on the bottom of the device and the read-out is carried out by a magnetic tunnel junction (MTJ) which is arranged on top of the RT layer. In this layer design the RT layer is a free/exposed layer, so that when the contacting electrodes (metal layer) are manufactured on top of this exposed layer, there is a high risk of damaging the exposed RT layer during etching (so-called over-etching) of the metallic layer.
2. On the other hand, when the etching process is not complete, the device would be shortened through the remaining (excess) top conducting electrode material. The margin between over-etching and incomplete etching in these devices is so small that fabrication of reliable chips is a real challenge, and the yield can be very poor.
3. With the conventional electrodes all being on top it becomes difficult to increase the chip density since it is hard to decrease the footprint and the distance between the electrodes.
4. Nucleation of DWs with the conventional electrode design on top is hard to accomplish, since spin torque switching (STT switching) may be needed to nucleate DWs in one side of the RT element; but this switching can be impeded or even impossible due to the typical MgO barrier between the MTJ layer and the RT layer which is thicker in RTMs than in conventional STT-MRAMs, and thus prevents passage of the high currents that might be needed, since the voltage across the MgO barrier is limited by the breakdown strength of the MgO layer.

It is therefore an object of the present invention to avoid or at least minimize the above shortcomings, and specifically to provide a manufacturing approach which allows for one or more of:
- a smaller footprint,
- an increased on-off TMR ratio,
- a nucleation of DWs near the edge of an electrode,
- only a single nucleation of a DW in the beginning within the factory,
- a decrease of voltage and current density at the electrodes, i.e. a decrease of channel resistance,
- a reduction of the stray tunneling current across the barrier,
- an improved thermal stability, and,
- an increased writing speed at a given current density.

### BRIEF DESCRIPTION OF THE INVENTION

In order to solve the above problems, the present invention provides a metallization layer forming one pair of electrodes as the bottom layer and another metallization layer as the outermost layer forming another electrode, wherein the two metallization layers sandwich at least one RT layer and at least one MTJ layer. Thus, the invention comprises a memory array device having the following layer sequence starting from the substrate:
o Substrate,
o Bottom metallization layer (=first metallization layer),
o At least two functional layers including a RT layer and a MTJ layer, and
o Outermost metallization layer (=second metallization layer).

Within this inventive concept it is important that - starting from the substrate, preferably a silicon substrate - a first metallization layer for forming one pair of electrodes is manufactured followed by the at least two functional layers, including at least one RT layer and at least one MTJ layer and a second metallization layer which is manufactured afterwards, i.e. subsequent to the functional layers and forming the topmost layer. Yet, this does not necessarily mean that a functional layer is directly and immediately manufactured on top of the first metallization layer or that the second metallization layer is manufactured directly and immediately on top of the last functional layer. Although this is preferred there may also be (an)other layer(s) between the first metallization layer and the functional layer and/or between the functional layers and/or between the last functional layer and the second metallization layer.

A typical RT layer consists of multiple layers which together form the RT layer. The basic structure of a racetrack is typically based on a ferromagnetic structure or a synthetic antiferromagnetic structure. The synthetic antiferromagnetic structure may be comprised of two ferromagnetic layers coupled antiferromagnetically via an antiferromagnetic coupling layer which is typically comprised of a transition metal like Ru or Ir. The ferromagnetic structure comprises one or more, preferably two or three layers of a ferromagnetic material which is typically selected from one or more of Co, Ni, or Fe or an alloy of Fe and/or Co, or an alloy of Ni that may further include one or more of Fe and Co. Typically, the racetrack structure has a total thickness in the range of 0.5 to 3.0 nm. Each individual layer of the racetrack structure may have a thickness in the range of 0.1 nm - 1.5 nm. The structure is composed of multiple thin magnetic layers so that the multilayered structure exhibits a PMA (Perpendicular Magnetic Ansotropy) that is usually derived from the interfacial properties of the multilayered structure.

A typical MTJ layer consists of two ferromagnetic layers separated by a thin, i.e. only a few nm thick insulator, like epitaxial MgO or amorphous Al₂O₃. The ferromagnetic layer itself comprises one or more, preferably two or three layers of a ferromagnetic material which is/are typically selected from one or more of Co, Ni, or Fe or an alloy of Fe and/or Co, or an alloy of Ni that may further include one or more of Fe and Co.

### DEFINITION OF TERMS

According to the present invention a "functional layer" is either a RT layer or a MTJ layer.

"Footprint" is the total area/volume of a complete 1-bit element, i.e. the space required for the stacked layers of electrodes (metallic layer), RT layer, barrier layer and MTJ layer.

"On-off TMR ratio" means the ratio of the on-state to the off-state of tunneling magnetoresistance of an MTJ.

"Nucleation of DW" means the creation of a magnetic domain wall; in a preferred embodiment only a single nucleation of DW is necessary at the time of manufacture of the RT device.

The "voltage" is the voltage applied to the channel, and the "current density" is the channel current divided by the cross section of channel, respectively; and the "channel resistance" is determined by the voltage divided by the channel current.

"Stray tunneling current" means the transient tunneling current across an MTJ when a current along the channel is applied to move domain walls.

"Thermal stability" means the degree to which domain walls stay stable at given positions for an extended period of time (>10 years) despite thermal variations.

"Writing speed" is defined as the switching speed of a device at a given current pulse at a given current density.

"RIE" means reactive ion etching; so called dry-etching, where plasma gas is applied to the elements to be etched.

"BEOL" means back end of line.

"FEOL" means front end of line.

"CMP" means chemical mechanical polishing, e.g. to planarize surfaces.

"MESA" (mesa) is an isolated flat, exposed, table-like top structure with about vertical cliffs at the edges.

### BRIEF DESCRIPTION OF DRAWINGS

Figure 1 shows the layer sequence in a RTM according to the state-of-the-art. Figure 1a is an electron micrograph and figure 1b is a graphical representation showing the layered design with the silicon substrate (1) being the bottom layer and subsequent embedded magnetic fixed region (2) - typically a hard magnetic material - within the SiO₂ layer (3) followed by the RT layer (4) and the MTJ layer (5) (and electric contacts (6)) and the top metallic layer forming the electrodes (7).

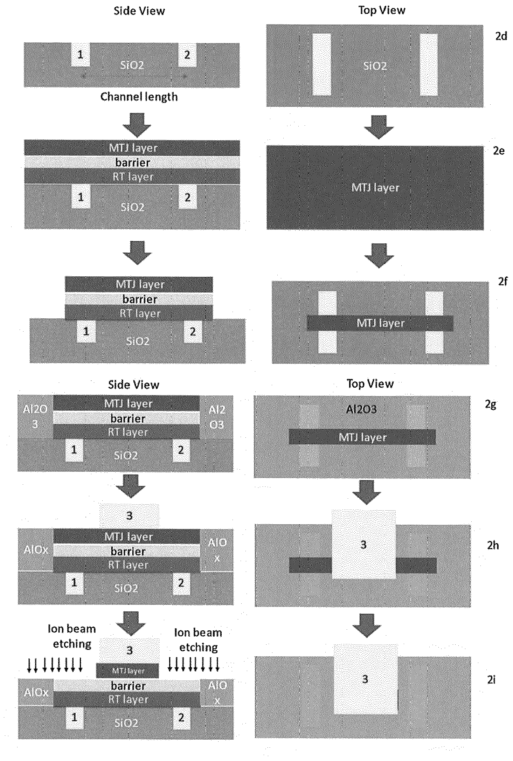

Figure 2 illustrates an exemplary concept of the present invention with separated electrodes. In a first step a substrate like a silicon wafer is covered with SiO₂ (Figure 2a). In a second step using e.g. reactive ion etching (RIE) the positions for two electrodes are etched out of the SiO₂ layer (Figure 2b); subsequently a metallic layer is deposited (Figure 2c) which is then polished e.g. by chemical mechanical polishing in order to planarize the surface (Figure 2d). Subsequently and one after the other the RT layer, a barrier layer and the MTJ layer are deposited (Figure 2e). In the next step the MTJ mesa is created, e.g. using e-beam lithography and ion beam etching (Figure 2f). The mesa is then encapsulated with Al₂O₃ leaving the top of the MTJ layer (mesa) exposed (Figure 2g). Another metallic layer is then deposited on top of the MTJ layer at a defined width (Figure 2h), which may be smaller than the width of the MTJ area, thus creating a third electrode. In a final step of the 1-bit 3-terminal RTM manufacturing the MTJ layer and part of the Al₂O₃ layer is partially etched away so as to be of about equivalent size of the electrode in order to maximize the on-off ratio (Figure 2i).

### DETAILED DESCRIPTION OF THE INVENTION

The concept of the present invention is to separate the "DW electrodes" from the MTJ electrode, by creating the DW electrodes on the bottom and the MTJ electrode at the top of the RTM. Accordingly, a first metallization layer is provided which forms one pair of electrodes as the bottom layer and another, the second metallization layer is provided as the outermost layer forming another electrode, wherein the two metallization layers sandwich at least one RT layer and at least one MTJ layer.
The RTM according to the invention is preferably built on a substrate. An appropriate material for the substrate is silicon. For the manufacture of the RTM the substrate is preferably provided as a flat, polished area (a wafer).

In a first step the substrate is covered with SiO₂ or any other suitable insulating dielectric material.

In a second step the positions for two electrodes - the DW electrodes, electrode 1 and 2 - are etched out of the SiO₂ layer (Figure 2b); a preferred etching process is reactive ion etching (RIE). The two recesses for the two DW electrodes each have a cross section of 20-30 nm, preferably 15-20 nm and most preferred 10-20 nm. The two electrodes are preferably spaced 20-30 nm apart (center to center; equivalent to the channel length; see Figure 2d), more preferred 15-20 nm and most preferred 10-20 nm. By minimizing the channel length between the two electrodes, the footprint of the RTM can be minimized. Moreover, by reducing the electrode width (=channel length), the on-off TMR ratio can be increased. Most importantly, a domain wall can be nucleated in the RT layer as initial DW at the time of manufacture by spin-orbit torque when current pulses are applied along either electrode 1 or 2 in the presence of an in-plane magnetic field that is parallel to the current flow direction. For example, when the current flows along the electrode 1, the domain wall is created in the track above the electrode 1.

Subsequently a metallic layer, the first metallic layer, is deposited (Figure 2c) over the structured SiO₂ layer. In general, any metal with a low resistance is suitable; preferably the conductivity of the metallic electrode should be at least 10X higher than the ferromagnetic channel. Preferably, this first metallic layer is polished e.g. using chemical mechanical polishing in order to planarize the surface (Figure 2d).

Subsequently and one after the other at least two functional layers are deposited. Since the two DW electrodes have already been formed it is preferred that a RT layer is deposited over the DW electrodes before a MTJ layer is deposited. It is also preferred that the RT layer and the MTJ layer are separated by a barrier layer (see Figure 2e). Any barrier layer with a good tunneling magnetoresistance can be used, e.g. Al₂O₃. Preferably typical CMOS technology is used for the manufacturing process (see e.g.: https://en.wikipedia.org/wiki/Semiconductor device fabrication). As an example, the layers can be fabricated using physical vapor deposition (PVD), such as cathodic arc deposition, electron-beam physical vapor deposition, evaporative deposition, close-space sublimation, pulsed laser deposition, magnetron sputter deposition, pulsed electron deposition, or the sublimation sandwich method.

In the next step the MTJ mesa is created, e.g. using e-beam lithography and ion beam etching (Figure 2f). The mesa laterally stretches over both RT electrodes 1 and 2 and preferably extends these on both sides. The size of mesa is only limited by the limitations of lithography. The smaller the mesa size the better.

The mesa is then encapsulated with a barrier material, preferably Al₂O₃, such that the barrier material is coplanar with the top of the MTJ layer (the top of the mesa), leaving the top of the MTJ layer exposed (see Figure 2g).

Another metallic layer - the second metallic layer - is then deposited on top of the MTJ layer (see Figure 2h) at a width, which may be smaller than the width of the MTJ area, thus creating a third electrode.

In a final step of the 1-bit 3-terminal RTM manufacturing process the MTJ layer and part of the Al₂O₃ wrapping is partially etched away so that the MTJ layer is reduced to about the size of the electrode (see Figure 2i). This has the effect of maximizing the on-off ratio.

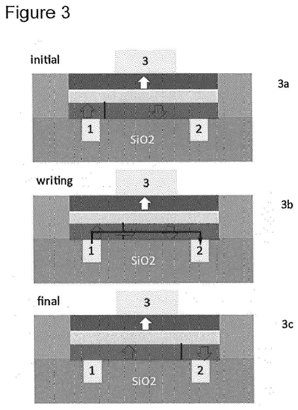

Figure 3 shows the working principle of a device according to the present invention. Initially (Figure 3a) here, the domain wall (DW) is on the left-side in the RT layer. Here the domain wall configuration is up | down. Since the magnetization of the MTJ layer is up, the MTJ device is in the off-state (high resistance state). A current pulse is applied from the electrode 1 to 2 to move the DW (Figure 3b), which would result in the MTJ device on-state. Note that the tunneling barrier is thick enough to minimize possible stray current from the electrode 1 to electrode 3. Finally (Figure 3c), the DW is on the right-side in the track layer. The DW configuration is down | up. So the MTJ device is in the on-state. If the current flows in the opposite direction (from the electrode 2 to 1), the MTJ state would be switched from the on-state to the off-state.

### ADVANTAGES OF THE INVENTION

By minimizing the channel length between the electrode 1 and 2, the device footprint is minimized. By reducing the width (=distance) of electrodes 1 and 2, and also by ionbeam etching of the recesses for electrodes 1 and 2 the on-off TMR ratio can be increased.

Since the overall device size is determined by the distance between electrodes 1 and 2 only, the RTM is easy to scale down. In principle, the channel length can be as small as the width of the DW width, i.e. preferably ~ 10 nm.

The initial nucleation of the DW occurs near the edge of electrode 1 and 2 due to the localized SOT (on the DW; not in other areas); this results from applying current pulse along either electrode 1 or 2 in the presence of an in-plane field H along the wire direction by SOT. Nucleation of DW is needed only once in the beginning at the factory like for 1-bit racetrack device.

The DW is tightly constrained within the channel under current pulses due to the dramatic decrease of current density at electrodes 1 and 2 (=strong DW pinning sites due to the dramatic decrease in current density at electrodes 1 and 2). This means that no extra structure (like an MgO barrier) is necessary to stop the DW at the end. Scaling down of the channel results in a decrease of resistance due to Ohm's law so that the voltage and current density decreases for moving the DW. This is important since the size of CMOS transistors that connect to each device highly depends on the current density. The higher the current density, the larger the CMOS transistor size which would ultimately limit the device density. In this connection it has to be born in mind that the current density is proportional to the DW velocity which in turn is determined by voltage, resistivity and channel length only. Accordingly, the downscaling which is possible with the present invention allows for 1T-1MTJ interconnection and, thus, results in a drastically decreased effort for interconnection wiring in the RTM. Every single MTJ can be used simultaneously as a pinning site, read unit and write unit.

### In summary: As the device scales down,

- the track resistance decreases by Ohm's law
- the MTJ resistance becomes much larger than the track resistance
- less stray current flows to the MTJ during writing process
- the MTJ barrier becomes more endurable because the channel becomes increasingly more conducting than the tunnel barrier
- the thermal stability is significantly improved by making constrictions near the electrodes 1 and 2 since the DW is trapped in the constrictions
- the DW is less likely pinned somewhere in the middle between electrode 1 and 2
- the writing speed of the device increases
   ∘ since the speed increases proportionally with a given current density; and
   ∘ since the capacitance of the MTJ decreases so that the RC constant decreases.

## Claims

1. Memory array device, including a racetrack layer, having the following layer sequence starting from the substrate:
∘ Substrate,
o Bottom metallization layer,
∘ At least two functional layers including a RT layer and a MTJ layer, and
o Outermost metallization layer.

2. Memory array device according to claim 1, wherein RT layer is next to the first metallization layer and the MTJ layer is next to the second metallization layer.

3. Memory array device according to claim 1 or 2, additionally including a barrier layer between the RT layer and the MTJ layer.

4. Memory array device according to claim 1, 2 or 3, wherein the RT layer is based on a ferromagnetic structure or a synthetic antiferromagnetic structure.

5. Memory array device according to claim 4, wherein the synthetic antiferromagnetic structure is comprised of two ferromagnetic layers coupled antiferromagnetically via a coupling layer.

6. Memory array device according to claim 5, wherein the coupling layer is comprised of a transition metal.

7. Memory array device according to claim 4, wherein the ferromagnetic structure comprises one or more, preferably two or three layers of a ferromagnetic material which is selected from one or more of Co, Ni, or Fe or an alloy of Fe and/or Co, or an alloy of Ni that may further include one or more of Fe and Co.

8. Memory array device according to any one of claims 1 to 6, wherein the RT layer has a total thickness in the range of 0.5 to 3.0 nm.

9. Memory array device according to claim 8, wherein each individual layer of the RT layer has a thickness in the range of 0.1 nm - 1.5 nm.

10. Process for manufacturing a memory array device according to claim 1, comprising the steps of
∘ Providing a substrate
o Covering the substrate with an insulating dielectric material
o Etching out the positions for two electrodes
∘ Depositing a first metallic layer over the structured substrate layer
∘ Planarizing the metallic layer, thereby creating two electrodes
o Depositing at least two functional layers one after the at least other, wherein the functional layers are selected from a RT layer and a MTJ layer
∘ Creating a mesa
o Encapsulating the mesa with a barrier material, such that the barrier material is coplanar with the top layer of the functional layers, leaving the top layer of the functional layers exposed
∘ Depositing a second metallic layer on the top layer of the functional layers thus creating a third electrode
∘ Etching the top layer of the functional layers and part of the barrier material wrapping partially away so that the top layer of the functional layers is reduced to about the size of the third electrode.

11. Process according to claim 10, wherein a RT layer is deposited over the first metallic layer before a MTJ layer is deposited.

12. Process according to claim 10, wherein a barrier layer is manufactured between the RT layer and the MTJ layer.
